# EUROPEAN PATENT APPLICATION

(11) **EP 4 836 276 A1**
(43) Date of publication of application: **04.11.2026**
(21) Application number: 24910213.8
(22) Date of filing: 23.10.2024
(51) Int. Cl.: H02M 7/00, H02M 1/00

(54) **INVERTER, MOTOR CONTROLLER, POWERTRAIN, AND VEHICLE**

(30) Priority: 29.12.2023 CN 202311867170
(71) Applicant: BYD Company Limited, Shenzhen, Guangdong 518118 (CN)
(72) Inventor: XU, Luhui, Shenzhen, Guangdong 518118 (CN); LIN, Xiaofeng, Shenzhen, Guangdong 518118 (CN); ZHANG, Youxin, Shenzhen, Guangdong 518118 (CN); NING, Hangbo, Shenzhen, Guangdong 518118 (CN); LI, Bin, Shenzhen, Guangdong 518118 (CN)
(74) Representative: Mathys & Squire
(86) International application number: PCT/CN2024/126599
(87) International publication number: WO 2025/139272

(57) **Abstract**

Disclosed are an inverter (10), a motor control unit, a powertrain, and a vehicle. The inverter (10) is used for the motor control unit and includes a power transistor (11) and a capacitor core (19). The power transistor (11) includes a power transistor body (100) and a direct current terminal 35 connected to the power transistor body (100). The capacitor core (19) and the power transistor (11) are arranged in a first direction. The first direction is substantially perpendicular to the power transistor body (100). The capacitor core (19) includes a core conductive plate (200), and the core conductive plate (200) includes a connection end. The connection end is disposed at a first axial end of the capacitor core (19). The direct current terminal (35) is located adjacent to the first axial end of the capacitor core (19). The connection end is connected to the direct current terminal (35). In this application, a volume of the inverter (10) is reduced.

## Description

This application claims priority to Chinese Patent Application No. 202311867170.5, filed with the China National Intellectual Property Administration on December 29, 2023 and entitled "INVERTER, MOTOR CONTROL UNIT, POWERTRAIN, AND VEHICLE", which is incorporated herein by reference in its entirety.

### TECHNICAL FIELD

This application relates to the field of electronic and electrical technologies, and specifically, to an inverter, a motor control unit, a powertrain, and a vehicle.

### BACKGROUND

An inverter enables conversion of direct current into alternating current, and may serve as a core component of a drive motor or a charging system, thereby being widely used in vehicles. In conventional technologies, due to non-optimal arrangement of capacitors and power transistors, the motor control unit usually has an irregular shape, or an overall volume of the motor control unit is large.

### SUMMARY

An objective of this application is to provide an inverter, a motor control unit, a powertrain, and a vehicle, to resolve the problem of a large sized inverter.

To achieve the objective of this application, this application provides the following technical solutions.

According to a first aspect, this application provides an inverter, including:
a power transistor, wherein the power transistor includes a power transistor body and a direct current terminal connected to the power transistor body; and
a capacitor core, wherein the capacitor core and the power transistor are arranged in a first direction, the first direction being substantially perpendicular to the power transistor body, the capacitor core including a core conductive plate, the core conductive plate including a connection end, the connection end being disposed at a first axial end of the capacitor core, the direct current terminal being located adjacent to the first axial end of the capacitor core, and the connection end being connected to the direct current terminal.

In an implementation, the inverter further includes a first heat dissipation plate, and the first heat dissipation plate is disposed between the capacitor core and the power transistor body in the first direction.

In an implementation, the inverter further includes a first drive board, and the first drive board is disposed between the capacitor core and the first heat dissipation plate in the first direction.

In an implementation, the core conductive plate includes a first conductive plate and a second conductive plate, the first conductive plate has a first connection end, the second conductive plate has a second connection end, and the first connection end and the second connection end are disposed close to the first axial end of the capacitor core; and
the first connection end and the second connection end are disposed on a first side face of the capacitor core, the first side face is close to the power transistor, the first connection end and the second connection end are stacked and spaced apart at the first axial end of the capacitor core, the direct current terminal includes a first connection terminal and a second connection terminal, the first connection terminal is connected to the first connection end, and the second connection terminal is connected to the second connection end.

In an implementation, the first conductive plate further has a third connection end, the second conductive plate further has a fourth connection end, the third connection end and the fourth connection end are close to a second side face of the capacitor core, and the second side face is away from the power transistor.

In an implementation, the power transistor includes a first sub-power transistor and a second sub-power transistor, the power transistor body includes a first sub-power transistor body and a second sub-power transistor body, the first sub-power transistor includes the first sub-power transistor body and the first connection terminal, the second sub-power transistor includes the second sub-power transistor body and the second connection terminal, and the first sub-power transistor body and the second sub-power transistor body are stacked and spaced apart in the first direction.

In an implementation, the first sub-power transistor further includes a first alternating current terminal, the second sub-power transistor further includes a second alternating current terminal, the first alternating current terminal and the second alternating current terminal are disposed close to a second axial end of the capacitor core, and the first alternating current terminal is electrically connected to the second alternating current terminal.

In an implementation, the first sub-power transistor further includes a first signal end, the first signal end extending in a direction away from the second sub-power transistor body, the second sub-power transistor further including a second signal end, and the second signal end extending in a direction away from the first sub-power transistor body; and
the inverter further includes a first drive board and a second drive board; the first drive board being disposed on a side of the first sub-power transistor body that is away from the second sub-power transistor in the first direction, and being connected to the first signal end; and the second drive board being disposed on a side of the second sub-power transistor body that is away from the first sub-power transistor body in the first direction, and being connected to the second signal end.

In an implementation, the inverter further includes a second heat dissipation plate, the second heat dissipation plate is disposed between the first sub-power transistor body and the second sub-power transistor body, the second heat dissipation plate includes a first surface and a second surface that are opposite to each other, the first sub-power transistor body being disposed on the first surface, and the second sub-power transistor body being disposed on the second surface; and
a top of the second heat dissipation plate is close to the first axial end of the capacitor core, and a bottom of the second heat dissipation plate is close to a second axial end of the capacitor core.

In an implementation, there are a plurality of first sub-power transistors, the plurality of first sub-power transistors being disposed in parallel in a second direction, there are a plurality of second sub-power transistors, the plurality of second sub-power transistors being disposed in parallel in the second direction, and each first sub-power transistor and one second sub-power transistor are electrically connected in a one-to-one correspondence in the first direction, and the second direction intersects the first direction.

In an implementation, the inverter further includes a third heat dissipation plate, and the third heat dissipation plate is disposed between the second sub-power transistor body and the second drive board.

In an implementation, the third heat dissipation plate includes a liquid inlet pipe and a liquid outlet pipe, an axis of the liquid inlet pipe being approximately perpendicular to the third heat dissipation plate, an axis of the liquid outlet pipe being approximately perpendicular to the third heat dissipation plate, the liquid inlet pipe being configured to allow coolant to flow in, and the liquid outlet pipe being configured to allow the coolant to flow out.

In an implementation, a first through hole and a second through hole are provided in the second drive board, the liquid inlet pipe passes through the first through hole, and the liquid outlet pipe passes through the second through hole.

In an implementation, the first drive board and the second drive board are connected through at least one connector.

In an implementation, the inverter further includes a case, and the capacitor core and the power transistor are jointly potted in the case.

In an implementation, the inverter further includes a case, a capacitor shell, and an adhesive member. The capacitor core is potted in the capacitor shell to form a capacitor module. The capacitor module and the power transistor are disposed in the case through the adhesive member.

In an implementation, a size of the inverter in the first direction is L1, a size of the inverter in the second direction is L2, satisfying 0.9≤L1/L2≤1.1, and the second direction intersects the first direction.

According to a second aspect, this application further provides a motor control unit, including the inverter according to the first aspect.

According to a third aspect, this application further provides a powertrain, including the motor control unit according to the second aspect.

According to a fourth aspect, this application further provides a vehicle, including the powertrain according to the third aspect.

The power transistor and the capacitor core are provided, the power transistor includes a power transistor body and a direct current terminal connected to the power transistor body, the capacitor core and the power transistor are arranged in the first direction, and the first direction is substantially perpendicular to the power transistor body, such that the power transistor body is in an upright state relative to the capacitor core. In addition, the connection end of the core conductive plate of the capacitor core is disposed at the first axial end of the capacitor core, and the direct current terminal is located adjacent to the first axial end of the capacitor core, so that a side of the power transistor body that is connected to the direct current terminal is substantially flush with the first axial end of the capacitor core. As a result, a structural arrangement becomes more compact, a spatial layout becomes more optimised, and an overall volume of the inverter is reduced.

### BRIEF DESCRIPTION OF DRAWINGS

In order to more clearly illustrate a technical solution in an implementation of this application or in the prior art, the drawings that need to be used in the description of the implementation or the prior art are briefly introduced below. Obviously, the drawings described below are only some implementations of this application. For a person of ordinary skill in the art, other drawings may be obtained based on these drawings without creative efforts.
FIG. 1 is an exploded view of a structure of an inverter according to an embodiment;
FIG. 2 is a first assembly diagram of an inverter according to an embodiment;
FIG. 3 is a second assembly diagram of an inverter according to an embodiment;
FIG. 4 is a third assembly diagram of an inverter according to an embodiment;
FIG. 5 is a fourth assembly diagram of an inverter according to an embodiment; and
FIG. 6 is a diagram of a vehicle.

### Reference numerals:

10: inverter; 11: power transistor; 12: first sub-power transistor; 121: first signal end; 100: power transistor body; 122: first sub-power transistor body; 123: first alternating current terminal; 1231: first connection portion; 124: first connection terminal; 1241: first direct current connection portion; 13: second sub-power transistor; 131: second signal end; 132: second sub-power transistor body; 133: second alternating current terminal; 1331: second connection portion; 134: second connection terminal; 1341: second direct current connection portion; 14: first drive board; 15: second drive board; 30: connector; 31: threaded fastener; 16: first heat dissipation plate; 17: second heat dissipation plate; 18: third heat dissipation plate; 19: capacitor core; 1901: first side face; 1902: second side face; 20: liquid inlet pipe; 21: liquid outlet pipe; 22: case; 23: accommodating cavity; 24: first connection end; 25: second connection end; 27: third connection end; 28: fourth connection end; 26: connection plate; 261: first detection groove; 262: second detection groove; X: first direction; Z: third direction; Y: second direction; 200: core conductive plate; 240: first conductive plate; 250: second conductive plate; 35: direct current terminal; 36: connection end; 40: motor control unit; 50: powertrain; 60: vehicle.

### DESCRIPTION OF EMBODIMENTS

The following clearly and completely describes the technical solutions in implementations of this application with reference to the accompanying drawings in the implementations of this application. It is clear that the described implementations are merely some but not all of the implementations of this application. All other implementations obtained by a person of ordinary skill in the art based on the implementations of this application without creative efforts shall fall within the protection scope of this application.

It will be noted that when an assembly is referred to as being "fastened to" another assembly, the assembly may be directly on another assembly or there may be an intermediate assembly. When an assembly is considered to be "connected" to another assembly, the assembly may be directly connected to another assembly or there may be an intermediate assembly at the same time.

Unless otherwise defined, all technical and scientific terms used in this application have the same meanings as commonly understood by a person of ordinary skill in the art to which this application belongs. Terms used in this specification of this application are only for the objective of describing specific embodiments and are not intended to limit this application. The term "and/or" as used in this application includes any and all combinations of one or more of associated listed items.

The following describes in detail some implementations of this application with reference to accompanying drawings. In the absence of conflict, the following embodiments and features within the embodiments may be combined with each other.

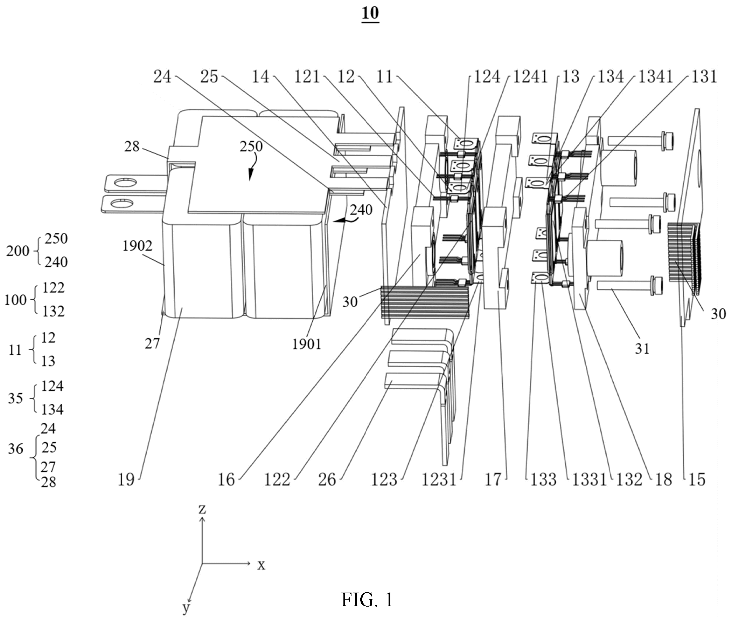

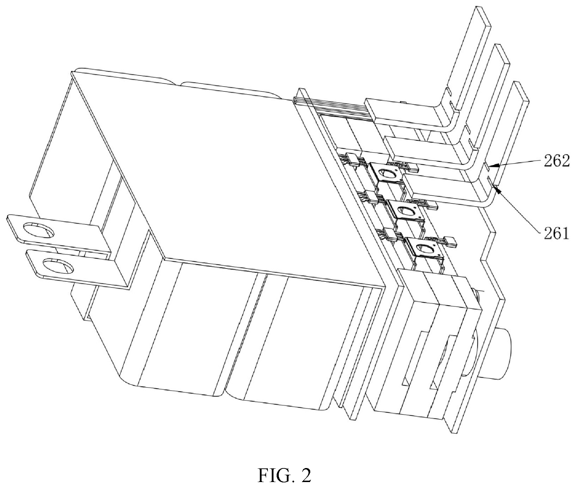

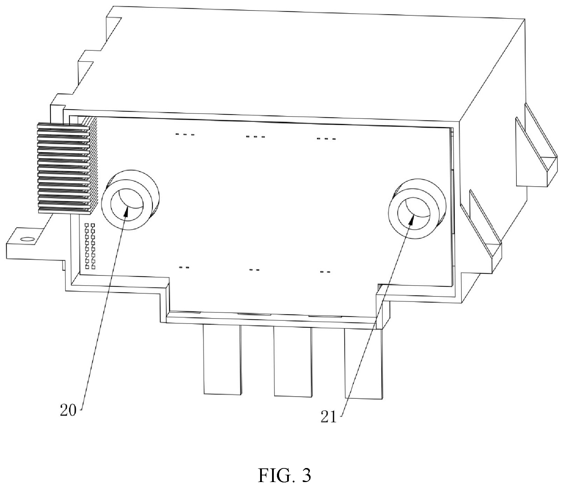

An embodiment of this application provides an inverter 10. Reference is made to FIG. 1, FIG. 2, and FIG. 3. The inverter 10 includes a power transistor 11, a heat dissipation plate, a capacitor core 19, and a core conductive plate 200.

The power transistor 11 includes a power transistor body and a direct current terminal 35 connected to the power transistor body.

The capacitor core 19 and the power transistor 11 are arranged in a first direction X, the first direction X is substantially perpendicular to the power transistor body, the capacitor core 19 includes a core conductive plate 200, the core conductive plate 200 includes a connection end 36, the connection end 36 is disposed at a first axial end of the capacitor core 19, the direct current terminal 35 is located adjacent to the first axial end of the capacitor core 19, and the connection end 36 is connected to the direct current terminal 35. Preferably, the first direction is substantially perpendicular to an axial direction of the capacitor core 19.

It will be noted that all substantially perpendicular in this application means approximately 90°, for example, any included angle between 85° and 90°.

In related technologies, a power transistor 11 and a drive board are usually sequentially disposed in an axial direction of a capacitor core 19, resulting in an excessively large axial space of the capacitor core 19, and difficulty in assembly. In addition, a core conductive plate 200 usually extends from a side face of the capacitor core 19, and a direct current terminal 35 of the power transistor 11 also extends from the same side face, for example, one side face in a first direction X, and then the core conductive plate 200 is connected to the direct current terminal 35. A connection point between the core conductive plate 200 and the direct current terminal 35 is usually formed by a connection sheet perpendicular to an axial direction of the capacitor core 19. Two connection sheets are thin while an axial height of the capacitor core 19 is high. Consequently, axial space at the connection between the core conductive plate 200 and the direct current terminal 35 cannot be fully utilized.

In the related technologies, the power transistor 11 is alternatively disposed on a side face of the capacitor core 19, that is, the power transistor 11 and the capacitor core 19 are sequentially disposed in the first direction X, and a power transistor body is usually parallel to the first direction X. It will be understood that the power transistor 11 is laid flat. In the axial direction of the capacitor core 19, a size of the power transistor 11 is far less than a size of the capacitor core 19. Because the power transistor 11 is arranged in a laid-flat configuration, a large amount of space corresponding to a position of the power transistor 11 in the axial direction of the capacitor core 19 cannot be effectively utilized, thereby causing an overall size of a controller to be large.

The power transistor 11 and the capacitor core 19 are provided, the power transistor 11 includes a power transistor body and a direct current terminal 35 connected to the power transistor body, the capacitor core 19 and the power transistor 11 are arranged in the first direction X, and the first direction X is substantially perpendicular to the power transistor body, such that the power transistor body is in an upright state relative to the capacitor core 19. In addition, the connection end 36 of the core conductive plate 200 of the capacitor core 19 is disposed at the first axial end of the capacitor core 19, and the direct current terminal 35 is located adjacent to the first axial end of the capacitor core 19, so that a side of the power transistor body that is connected to the direct current terminal 35 is substantially flush with the first axial end of the capacitor core 19. As a result, the structural arrangement becomes more compact, spatial layout becomes more optimised, and an overall volume of the inverter is reduced.

In an embodiment, reference is made to FIG. 1, FIG. 2, and FIG. 3. The inverter 10 further includes a first heat dissipation plate 16, and the first heat dissipation plate 16 is disposed between the capacitor core 19 and the power transistor body 100 in the first direction X.

The capacitor core 19 and the power transistor 11 are arranged in the first direction X, and the connection end 36 is also connected to the direct current terminal 35 in the first direction X. Therefore, sizes of the connection end 36 and the direct current terminal 35 in the axial direction of the capacitor core 19 are much smaller than sizes of the capacitor core 19 and the power transistor body 100 in the axial direction of the capacitor core. The first heat dissipation plate 16 is disposed between the capacitor core 19 and the power transistor body 100. The first heat dissipation plate 16 occupies space at a connection position of the core conductive plate 200 and the direct current terminal 35, so that a layout of the entire inverter 10 is more compact in the first direction X.

Optionally, a shape of the first heat dissipation plate 16 is one of the following: a polygon, a circle, an ellipse, and an irregular shape. The shape of the first heat dissipation plate 16 may be specifically, but is not limited to, a quadrilateral, a pentagon, a hexagon, an octagon, a circle, an ellipse, or the like.

Optionally, the connection between the connection end 36 and the direct current terminal 35 may reuse a size of the first heat dissipation plate 16 in the first direction X.

Specifically, this arrangement of the first heat dissipation plate 16 improves a heat dissipation capability of the inverter 10.

In an embodiment, reference is made to FIG. 1, FIG. 2, and FIG. 3. The inverter 10 further includes a first drive board 14, and the first drive board 14 is disposed between the capacitor core 19 and the first heat dissipation plate 16 in the first direction X.

The first drive board 14 is disposed between the capacitor core 19 and the first heat dissipation plate 16. The first drive board 14 also occupies the space at the connection position of the core conductive plate 200 and the direct current terminal 35, so that the layout of the entire inverter 10 is more compact in the first direction X.

Optionally, a shape of the first drive board 14 is one of the following: a polygon, a circle, an ellipse, and an irregular shape. The shape of the first drive board 14 may be specifically, but is not limited to, a quadrilateral, a pentagon, a hexagon, an octagon, a circle, an ellipse, or the like.

Specifically, this arrangement of the first drive board 14 saves space of the inverter 10.

In an embodiment, reference is made to FIG. 1, FIG. 2, and FIG. 3. The core conductive plate 200 includes a first conductive plate 240 and a second conductive plate 250. The first conductive plate 240 has a first connection end 24. The second conductive plate 250 has a second connection end 25. The first connection end 24 and the second connection end 25 are disposed close to the first axial end of the capacitor core 19. The first connection end 24 and the second connection end 25 are disposed on a first side face 1901 of the capacitor core 19, and the first side face 1901 is close to the power transistor 11. The first connection end 24 and the second connection end 25 are stacked and spaced apart at the first axial end of the capacitor core 19. The direct current terminal 35 includes a first connection terminal 124 and a second connection terminal 134. The first connection terminal 124 is connected to the first connection end 24, and the second connection terminal 134 is connected to the second connection end 25. The connection end 36 includes the first connection end 24 and the second connection end 25.

Optionally, the first conductive plate 240 and the second conductive plate 250 are respectively connected to the first axial end of the capacitor core 19 and a second axial end of the capacitor core 19. Both the first conductive plate 240 and the second conductive plate 250 are disposed at least partially close to the first axial end of the capacitor core 19, and parts that of the first conductive plate 240 and the second conductive plate 250 and that are close to the first axial end of the capacitor core 19 are stacked and spaced apart.

Optionally, the first connection terminal 124 is electrically connected to the first connection end 24. The second connection terminal 134 is electrically connected to the second connection end 25. Optionally, the first conductive plate 240 and the second conductive plate 250 are spaced apart. Optionally, the parts of the first conductive plate 240 and the second conductive plate 250 that are close to the first axial end of the capacitor core 19 are stacked and spaced apart in a third direction Z.

Specifically, the foregoing arrangement of the first conductive plate 240 and the second conductive plate 250 saves space of the inverter 10, improves compactness of parts and components of the inverter 10, and enhances a process of converting direct current into alternating current.

Optionally, the first connection end 24 and the second connection end 25 are spaced apart. Optionally, materials of the first connection end 24, the second connection end 25, a third connection end 27, and the fourth connection end 28 are all copper.

Specifically, the foregoing arrangement of the first conductive plate 240 and the second conductive plate 250 saves space of the inverter 10, and enhances a process of converting direct current into alternating current.

In an embodiment, reference is made to FIG. 1, FIG. 2, and FIG. 3. The first conductive plate 240 further has a third connection end 27, the second conductive plate 250 further has a fourth connection end 28, the third connection end 27 and the fourth connection end 28 are close to a second side face 1902 of the capacitor core 19, and the second side face 1902 is away from the power transistor 11. The connection end 36 further includes the third connection end 27 and the fourth connection end 28.

Optionally, materials of the third connection end 27 and the fourth connection end 28 are both copper. Optionally, the third connection end 27 and the fourth connection end 28 are spaced apart. Specifically, this arrangement saves space of the inverter 10.

In an embodiment, reference is made to FIG. 1, FIG. 2, and FIG. 3. The power transistor 11 includes a first sub-power transistor 12 and a second sub-power transistor 13. The power transistor body 100 includes a first sub-power transistor body 122 and a second sub-power transistor body 132. The first sub-power transistor 12 includes the first sub-power transistor body 122 and the first connection terminal 124. The second sub-power transistor 13 includes the second sub-power transistor body 132 and the second connection terminal 134. The first sub-power transistor body 122 and the second sub-power transistor body 132 are stacked and spaced apart in the first direction X.

Optionally, the first sub-power transistor body 122 is electrically connected to the first connection terminal 124. The second sub-power transistor body 132 is electrically connected to the second connection terminal 134. Optionally, a current may be transmitted between the first sub-power transistor body 122 and the first connection terminal 124, and a current may be transmitted between the second sub-power transistor body 132 and the second connection terminal 134.

Specifically, this arrangement of the first sub-power transistor 12 and the second sub-power transistor 13 saves space of the inverter 10, and enhances a process of converting direct current into alternating current.

Specifically, the first sub-power transistor body 122 and the second sub-power transistor body 132 are stacked and spaced apart in the first direction X, so that a quantity of power transistors 11 arranged in a second direction Y can be reduced. With this arrangement, a size of the power transistor 11 in the second direction Y does not exceed a size of the capacitor core 19.

In an embodiment, reference is made to FIG. 1, FIG. 2, and FIG. 3, optionally, the first connection terminal 124 includes a first direct current connection portion 1241. One end of the first direct current connection portion 1241 is connected to the first sub-power transistor body 122, and the other end extends toward a first connection sheet and is connected to the first connection end. The second connection terminal 134 includes a second direct current connection portion 1341. One end of the second direct current connection portion 1341 is connected to the second sub-power transistor body 132, and the other end extends toward a second connection sheet and is connected to the second connection end.

Optionally, a current may be transmitted between the first direct current connection portion 1241 and the first sub-power transistor body 122, and a current may be transmitted between the second direct current connection portion 1341 and the second sub-power transistor body 132.

Optionally, the first direct current connection portion 1241 is in a bent shape. Optionally, the second direct current connection portion 1341 is in a bent shape. Optionally, the first direct current connection portion 1241 is in an "L" shape. Optionally, the second direct current connection portion 1341 is in an "L" shape. Optionally, there are a plurality of first direct current connection portions 1241, and there are a plurality of second direct current connection portions 1341.

Optionally, the first direct current connection portion 1241 and the second direct current connection portion 1341 are spaced apart. Optionally, the first direct current connection portion 1241 and the second direct current connection portion 1341 are arranged at the same spacing.

Optionally, the foregoing arrangement of the first direct current connection portion 1241 and the second direct current connection portion 1341 saves space of the inverter 10, and improves compactness of parts and components of the inverter 10.

In an embodiment, reference is made to FIG. 1, FIG. 2, and FIG. 3. The first sub-power transistor 12 further includes a first alternating current terminal 123, and the second sub-power transistor 13 further includes a second alternating current terminal 133. The first alternating current terminal 123 and the second alternating current terminal 133 are disposed close to the second axial end of the capacitor core 19. The first alternating current terminal 123 is electrically connected to the second alternating current terminal 133. With this arrangement, the first sub-power transistor 12 and the second sub-power transistor 13 are connected as a one-phase bridge arm, and the two sub-power transistors are stacked in the first direction X. When the first sub-power transistor 12 is turned on, the second sub-power transistor body 132 connected to the first sub-power transistor body 122 is reversely biased. As a result, a reverse recovery current opposite to an internal current of the first sub-power transistor 12 is generated in the second sub-power transistor body 132. A magnetic field generated by the reverse recovery current and a magnetic field generated by a current in the first sub-power transistor body 122 counteract each other, thereby reducing stray inductance in a circuit of a power module and improving electromagnetic compatibility of the power module.

Optionally, the first sub-power transistor body 122 is connected to the first alternating current terminal 123, and the second sub-power transistor body 132 is connected to the second alternating current terminal 133. Optionally, a current may be transmitted between the first sub-power transistor body 122 and the first alternating current terminal 123, and a current may be transmitted between the second sub-power transistor body 132 and the second alternating current terminal 133. Optionally, the first alternating current terminal 123 and the second alternating current terminal 133 are stacked in the third direction Z.

Specifically, the foregoing arrangement of the first alternating current terminal 123 and the second alternating current terminal 133 saves space of the inverter 10, and enhances a process of converting direct current into alternating current.

Optionally, reference is made to FIG. 1, FIG. 2, and FIG. 3. The first alternating current terminal 123 further includes a first connection portion 1231. One end of the first connection portion 1231 is connected to the first sub-power transistor body 122, and the other end extends toward the second sub-power transistor 13.

The second alternating current terminal 133 includes a second connection portion 1331. One end of the second connection portion 1331 is connected to the second sub-power transistor body 132, and the other end extends toward the first sub-power transistor 12 and is connected to the first connection portion 1231.

Optionally, the first alternating current terminal 123 and the second alternating current terminal 133 are located on the same side of the third direction Z. Specifically, the first alternating current terminal 123 and the second alternating current terminal 133 provide a circuit for converting direct current into alternating current for the inverter 10.

Optionally, there are a plurality of first alternating current terminals 123, and there are a plurality of second alternating current terminals 133. Optionally, the first connection portion 1231 is in a bent shape. Optionally, the second connection portion 1331 is in a bent shape. Optionally, the first connection portion 1231 is in an "L" shape. Optionally, the second connection portion 1331 is in an "L" shape.

Specifically, this arrangement of the first connection portion 1231 and the second connection portion 1331 saves space of the inverter 10, and improves compactness of parts and components of the inverter 10.

Optionally, reference is made to FIG. 1, FIG. 2, and FIG. 3. The first connection portion 1231 and the second connection portion 1331 are stacked in the third direction Z and connected, and the second direction Y intersects the first direction X.

Optionally, there are a plurality of first connection portions 1231, and there are a plurality of second connection portions 1331. Optionally, each first connection portion 1231 and one second connection portion 1331 are stacked in a one-to-one correspondence. Optionally, the first connection portion 1231 and the second connection portion 1331 are stacked in the third direction Z and are electrically connected.

Specifically, the foregoing arrangement of the first connection portion 1231 and the second connection portion 1331 saves space of the inverter 10, and improves compactness of parts and components of the inverter 10.

In an embodiment, reference is made to FIG. 1, FIG. 2, and FIG. 3. The first sub-power transistor 12 further includes a first signal end 121, and the first signal end 121 extends in a direction away from the second sub-power transistor body 132. The second sub-power transistor 13 includes a second signal end 131, and the second signal end 131 extends in a direction away from the first sub-power transistor body 122.

The inverter 10 further includes a first drive board 14 and a second drive board 15. The first drive board 14 is disposed on a side of the first sub-power transistor body 122 that is away from the second sub-power transistor 13 in the first direction X, and is connected to the first signal end 121. The second drive board 15 is disposed on a side of the second sub-power transistor body 132 that is away from the first sub-power transistor body 122 in the first direction X, and is connected to the second signal end 131.

Optionally, there are a plurality of first signal ends 121, and there are a plurality of second signal ends 131. Optionally, the plurality of first signal ends 121 are spaced apart in the second direction Y, and the plurality of second signal ends 131 are spaced apart in the second direction Y. Optionally, each first signal end 121 and one second signal end 131 are disposed in a one-to-one correspondence in the first direction X.

Optionally, a shape of the second drive board 15 is one of the following: a polygon, a circle, an ellipse, and an irregular shape. The shape of the second drive board 15 may be specifically, but is not limited to, a quadrilateral, a pentagon, a hexagon, an octagon, a circle, an ellipse, or the like.

Optionally, a first pin header is disposed on the first drive board 14. The first drive board 14 is electrically connected to the second drive board 15 through the first pin header, and transmits a signal or a current through the first pin header. Optionally, a second pin header is disposed on the second drive board 15. The second drive board 15 is electrically connected to another external part through the second pin header, and transmits a signal or a current through the second pin header.

Specifically, there is one drive board in conventional technologies, and in this application, a drive board is split into a first drive board 14 and a second drive board 15. In this case, an area of a single drive board is reduced, and sizes of the first drive board 14 and the second drive board 15 do not exceed an entire module boundary.

In an assembly process of the inverter 10 in this application, one power transistor 11 is connected between the first drive board 14 and the second drive board 15, thereby improving flexibility of arrangement of the drive boards.

In an embodiment, reference is made to FIG. 1, FIG. 2, and FIG. 3. The inverter 10 further includes a second heat dissipation plate 17. The second heat dissipation plate 17 is disposed between the first sub-power transistor body 122 and the second sub-power transistor body 132. The second heat dissipation plate 17 includes a first face and a second face that are opposite to each other. The first sub-power transistor body 122 is disposed on the first surface, and the second sub-power transistor body 132 is disposed on the second surface.

A top of the second heat dissipation plate 17 is close to the first axial end of the capacitor core 19, and a bottom of the second heat dissipation plate 17 is close to a second axial end of the capacitor core 19.

Optionally, the first drive board 14 is disposed between the capacitor core 19 and the second heat dissipation plate 17. A side surface of the second heat dissipation plate 17, the first drive board 14, and the capacitor core 19 in the third direction Z jointly form a first connection surface. A side surface of the second heat dissipation plate 17, the first drive board 14, and the capacitor core 19 in the second direction Y jointly form a second connection surface.

Optionally, a first matching groove is provided at one end of the second heat dissipation plate 17 in the third direction Z, and a surface of a bottom wall of the first matching groove is recessed relative to the first connection surface. Optionally, a second matching groove is provided at the other end of the second heat dissipation plate 17 in the third direction Z, and a structure of the second fitting groove is the same as a structure of the first matching groove.

Optionally, the second heat dissipation plate 17 is disposed between the first sub-power transistor 12 and the second sub-power transistor 13 in the first direction X. Specifically, the second heat dissipation plate 17 improves the heat dissipation capability of the inverter 10.

In an embodiment, reference is made to FIG. 1, FIG. 2, and FIG. 3. There are a plurality of first sub-power transistors 12, and the plurality of first sub-power transistors 12 are disposed in parallel in the second direction Y. There are a plurality of second sub-power transistors 13, the plurality of second sub-power transistors 13 are disposed in parallel in the second direction Y, each first sub-power transistor 12 and one second sub-power transistor 13 are electrically connected in a one-to-one correspondence in the first direction X, and the second direction Y intersects the first direction X.

Optionally, the plurality of first sub-power transistors 12 are spaced apart in the second direction Y, and the plurality of second sub-power transistors 13 are spaced apart in the second direction Y.

Optionally, the plurality of first sub-power transistors 12 are arranged at the same spacing in the second direction Y, and the plurality of second sub-power transistors 13 are arranged at the same spacing in the second direction Y.

Specifically, the foregoing arrangement of the first sub-power transistor 12 and the second sub-power transistor 13 allows the first sub-power transistor 12 and the second sub-power transistor 13 to be arranged in a compact and orderly configuration.

Optionally, the foregoing arrangement of the plurality of first sub-power transistors 12 and the plurality of second sub-power transistors 13 saves space of the inverter 10, and improves compactness of parts and components of the inverter 10.

In an embodiment, reference is made to FIG. 1, FIG. 2, and FIG. 3. The inverter 10 further includes a third heat dissipation plate 18. The third heat dissipation plate 18 is disposed between the second sub-power transistor body 132 and the second drive board 15.

Optionally, the first heat dissipation plate 16 and the third heat dissipation plate 18 improve the heat dissipation capability of the inverter 10.

It will be noted that, in this application, optionally, the first sub-power transistor 12 further includes a first package body and a first sub-power transistor body 122. A first package cavity is formed in the first package body, and the first sub-power transistor body 122 is packaged in the first package cavity.

The second sub-power transistor 13 further includes a second package body and a second sub-power transistor body 132. A second package cavity is formed in the second package body, and the second sub-power transistor body 132 is packaged in the second package cavity.

Optionally, a shape of the first package cavity is one of the following: a polygon, a circle, an ellipse, and an irregular shape. The shape of the first package cavity may be specifically, but is not limited to, a quadrilateral, a pentagon, a hexagon, an octagon, a circle, an ellipse, or the like. Optionally, a shape of the second package cavity is one of the following: a polygon, a circle, an ellipse, and an irregular shape. The shape of the second package cavity may be specifically, but is not limited to, a quadrilateral, a pentagon, a hexagon, an octagon, a circle, an ellipse, or the like.

Specifically, arrangement of the first package body and the second package body improves a level of fastening the first sub-power transistor body 122 and the second sub-power transistor body 132.

In an embodiment, reference is made to FIG. 1, FIG. 2, and FIG. 3. The third heat dissipation plate 18 includes a liquid inlet pipe 20 and a liquid outlet pipe 21. An axis of the liquid inlet pipe 20 is approximately perpendicular to the third heat dissipation plate 18, and an axis of the liquid outlet pipe 21 is approximately perpendicular to the third heat dissipation plate 18. The liquid inlet pipe 20 is configured to allow coolant to flow in, and the liquid outlet pipe 21 is configured to allow the coolant to flow out.

Optionally, the axis of the liquid inlet pipe 20 is perpendicular to the third heat dissipation plate 18, and the axis of the liquid outlet pipe 21 is perpendicular to the third heat dissipation plate 18.

Specifically, this arrangement of the liquid inlet pipe 20 and the liquid outlet pipe 21 improves the heat dissipation capability of the inverter 10.

In an embodiment, reference is made to FIG. 1, FIG. 2, and FIG. 3. A first through-hole and a second through-hole are provided in the second drive board 15. The liquid inlet pipe 20 passes through the first through-hole, and the liquid outlet pipe 21 passes through the second through-hole.

Optionally, a shape of the first through-hole may be one of the following: a polygon, a circle, an ellipse, an irregular shape, and the like. Optionally, the shape of the first through hole may be specifically, but is not limited to, a quadrilateral, a pentagon, a hexagon, an octagon, a circle, an ellipse, or the like.

Optionally, a shape of the second through-hole may be one of the following: a polygon, a circle, an ellipse, an irregular shape, and the like. Optionally, the shape of the second through hole may be specifically, but is not limited to, a quadrilateral, a pentagon, a hexagon, an octagon, a circle, an ellipse, or the like.

Specifically, this arrangement of the first through-hole and the second through-hole improves stability of fastening the liquid inlet pipe 20 and the liquid outlet pipe 21.

It will be noted that, in this application, optionally, the second heat dissipation plate 17 is provided with a first heat exchange cavity, the first heat dissipation plate 16 is provided with a second heat exchange cavity, the third heat dissipation plate 18 is provided with a third heat exchange cavity, and the first heat exchange cavity, the second heat exchange cavity and the third heat exchange cavity communicate with each other.

Optionally, the first heat exchange cavity is used to allow coolant to flow, the second heat exchange cavity is used to allow the coolant to flow, and the third heat exchange cavity is used to allow the coolant to flow. Flow directions of the coolant in the first heat exchange cavity, the second heat exchange cavity, and the third heat exchange cavity are not limited.

Specifically, the foregoing arrangement of the first heat exchange cavity, the second heat exchange cavity, and the third heat exchange cavity improve heat dissipation effect of the inverter 10.

In an embodiment, reference is made to FIG. 1, FIG. 2, and FIG. 3. The first drive board 14 and the second drive board 15 are connected through at least one connector 30.

Optionally, arrangement of the at least one connector 30 improves stability of the connection between the first drive board 14 and the second drive board 15.

It will be noted that, in this application, optionally, the second heat dissipation plate 17, the first heat dissipation plate 16, and the third heat dissipation plate 18 are fastened.

Optionally, the inverter 10 further includes a plurality of threaded fasteners 31. The plurality of threaded fasteners 31 are spaced apart, and the second heat dissipation plate 17 is provided with a first mounting hole. The first heat dissipation plate 16 is provided with a second mounting hole. The third heat dissipation plate 18 is provided with a third mounting hole. The threaded fasteners 31 sequentially pass through the first mounting hole, the second mounting hole, and the third mounting hole, to connect the second heat dissipation plate 17, the first heat dissipation plate 16, and the third heat dissipation plate 18 to each other, so that the second heat dissipation plate 17, the first heat dissipation plate 16, and the third heat dissipation plate 18 are tightly connected to each other.

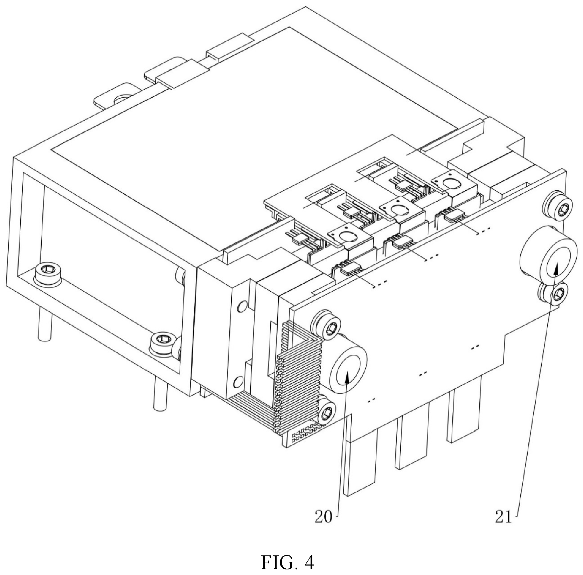

In an embodiment, reference is made to FIG. 1, FIG. 2, FIG. 3, FIG. 4, and FIG. 5. The inverter 10 further includes a case 22, and the capacitor core 19 and the power transistor 11 are jointly potted in the case 22.

Specifically, this arrangement provides a support function and an insulation function for the capacitor core 19 and the power transistor 11.

In an embodiment, reference is made to FIG. 1, FIG. 2, FIG. 3, FIG. 4, and FIG. 5. The inverter 10 further includes the case 22, a capacitor shell, and an adhesive member (not shown). The capacitor core 19 is potted in the capacitor shell to form a capacitor module. The capacitor module and the power transistor 11 are disposed in the case 22 through the adhesive member.

Optionally, the case 22 defines an accommodating cavity 23. The inverter 10 further includes the adhesive member. The capacitor core 19, the power transistor 11, the first drive board 14, and the second drive board 15 are accommodated in the accommodating cavity 23. The adhesive member covers outer peripheries of the capacitor core 19, the power transistor 11, the first drive board 14, and the second drive board 15. The case 22 surrounds an outer periphery of the adhesive member, thereby packaging the capacitor core 19 and the power transistor 11 together and improving effect of packaging the capacitor core 19 and the power transistor 11. Optionally, the adhesive member is liquid adhesive, and a material of the adhesive member may be epoxy resin.

Optionally, the case 22 is a plastic product, and the inverter 10 is integrally potted and fastened in the case 22.

Optionally, a shape of a cross section of the case 22 may be one of the following: a polygon, a circle, an ellipse, an irregular shape, and the like. Optionally, the shape of the cross section of the case 22 may be specifically, but is not limited to, a quadrilateral, a pentagon, a hexagon, an octagon, a circle, an ellipse, or the like.

Specifically, heights of all parts in the case 22 in the second direction Y are the same, and a size of another part of the inverter 10 in the first direction X and the third direction Z are the same as that of the power transistor 11. Specifically, in an assembly process of the inverter 10, only a few threaded fasteners are used to fasten parts, thereby simplifying a mounting process and reducing costs.

In an embodiment, reference is made to FIG. 1, FIG. 2, FIG. 3, and FIG. 4. A size of the power transistor 11 in the second direction Y is the same as that of the capacitor core 19 in the second direction Y, and the first direction X intersects the second direction Y.

Optionally, a size of the power transistor 11 in the third direction Z is the same as that of the capacitor core 19 in the third direction Z, and the first direction X intersects the second direction Y. Optionally, heights of all parts of the inverter 10 in the third direction Z are the same, and are the same as a height of the power transistor 11.

Specifically, this configuration facilitates platformization of the inverter 10, saves space of the inverter 10, and improves compactness of parts and components of the inverter 10.

In an embodiment, reference is made to FIG. 1, FIG. 2, FIG. 3, and FIG. 4. A size of the inverter 10 in the first direction X is L1, a size of the inverter 10 in the second direction Y is L2, satisfying 0.9≤L1/L2≤1.1, and the second direction Y intersects the first direction X.

Optionally, the first direction X, the second direction Y, and the third direction Z are perpendicular to each other.

Optionally, a result of L1/L2 may be specifically but is not limited to 0.9, 1.0, 1.1, or the like.

Optionally, the specific size of the inverter 10 in the first direction X may be appropriately extended for adaptation according to capacitance and voltage requirements of the capacitor core 19, thereby improving adaptability of the inverter 10. In addition, this dimensional configuration is applicable to a complex assembly environment, and facilitates development of a platform-based product.

In an embodiment, reference is made to FIG. 1, FIG. 2, FIG. 3, and FIG. 4. Optionally, the inverter 10 further includes a connection plate 26. The connection plate 26 is adapted to be connected to a stator winding of a motor. The connection plate 26 includes a first section and a second section. The first section is connected to an electrical connection portion that corresponds to the first sub-power transistor 12 and the second sub-power transistor 13. The second section extends out of the case 22 in a direction parallel to the axial direction of the capacitor core 19.

Optionally, each connection plate 26 and one second alternating current terminal 133 are stacked and connected. Optionally, there are three connection plates 26, and each connection plate 26 is connected to one second alternating current terminal 133 in the second direction Y. Specifically, this arrangement of the connection plate 26 saves space of the inverter 10. Each connection plate 26 is provided with a first detection groove 261 and a second detection groove 262 that are opposite to each other, and the first detection groove 261 and the second detection groove 262 are staggered. Optionally, each connection plate 26 is provided with the first detection groove 261 and the second detection groove 262 that are opposite to each other, and the first detection groove 261 and the second detection groove 262 are staggered. Optionally, a shape of the first detection groove 261 may be one of the following: a polygon, a circle, an ellipse, an irregular shape, and the like. Optionally, the shape of the first detection groove 261 may be specifically, but is not limited to, a quadrilateral, a pentagon, a hexagon, an octagon, a circle, an ellipse, or the like. Optionally, a shape of the second detection groove 262 may be one of the following: a polygon, a circle, an ellipse, an irregular shape, and the like. Optionally, the second detection groove 262 may be specifically, but is not limited to, a quadrilateral, a pentagon, a hexagon, an octagon, a circle, an ellipse, or the like.

Specifically, the first detection groove 261 and the second detection groove 262 are used for current detection through a coreless Hall chip, thereby improving convenience of detection.

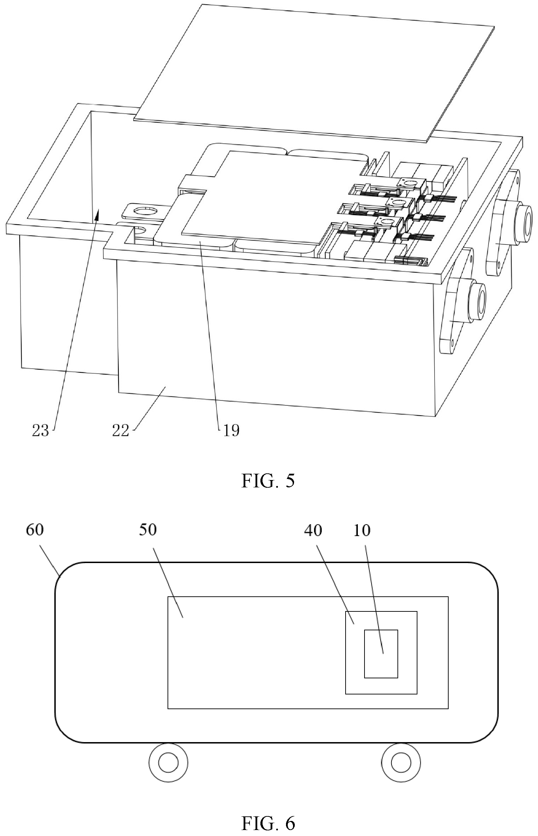

FIG. 6 shows a vehicle 60.

An embodiment of this application further provides a motor control unit 40, including the inverter 10.

An embodiment of this application further provides a powertrain 50, including the motor control unit 40.

An embodiment of this application further provides a vehicle 60, including the powertrain 50.

Optionally, the vehicle 60 is a family vehicle, a commercial vehicle, or the like.

In descriptions of embodiments of this application, it will be noted that orientation or position relationships indicated by terms "center", "above", "below", "left", "right", "vertical", "horizontal", "inner", "outer", and the like are orientation or position relationships based on the accompanying drawings, and are only intended to facilitate and simplify the description of this application, but are not intended to indicate or imply that an apparatus or an element needs to have a specific orientation and be constructed and operated in a specific orientation, and therefore will not be understood as a limitation on this application.

The foregoing disclosures are only example embodiments of this application, and certainly cannot be used to limit the scope of the claims of this application. A person of ordinary skill in the art will understand that all or some of the procedures of the foregoing embodiments and equivalent variations made according to this application still fall within the scope of this application.

## Claims

1. An inverter (10), comprising:
a power transistor (11), the power transistor (11) comprising a power transistor body (100) and a direct current terminal (35) connected to the power transistor body (100); and
a capacitor core (19), the capacitor core (19) and the power transistor (11) being arranged in a first direction, the first direction being substantially perpendicular to the power transistor body (100), the capacitor core (19) comprising a core conductive plate (200), the core conductive plate (200) comprising a connection end (36), the connection end (36) being disposed at a first axial end of the capacitor core (19), the direct current terminal (35) being located adjacent to the first axial end of the capacitor core (19), and the connection end (36) being connected to the direct current terminal (35).

2. The inverter (10) according to claim 1, wherein the inverter (10) further comprises a first heat dissipation plate (16), and the first heat dissipation plate (16) is disposed between the capacitor core (19) and the power transistor body (100) in the first direction.

3. The inverter (10) according to claim 2, wherein the inverter (10) further comprises a first drive board (14), and the first drive board (14) is disposed between the capacitor core (19) and the first heat dissipation plate (16) in the first direction.

4. The inverter (10) according to claim 2, wherein the core conductive plate (200) comprises a first conductive plate (240) and a second conductive plate (250), the first conductive plate (240) has a first connection end (24), the second conductive plate (250) has a second connection end (25), and the first connection end (24) and the second connection end (25) are disposed close to the first axial end of the capacitor core (19); and
the first connection end (24) and the second connection end (25) are disposed on a first side face (1901) of the capacitor core (19), the first side face (1901) is close to the power transistor (11), the first connection end (24) and the second connection end (25) are stacked and spaced apart at the first axial end of the capacitor core (19), the direct current terminal (35) comprises a first connection terminal (124) and a second connection terminal (134), the first connection terminal (124) is connected to the first connection end, and the second connection terminal (134) is connected to the second connection end (25).

5. The inverter (10) according to claim 4, wherein the first conductive plate (240) further has a third connection end (27), the second conductive plate (250) further has a fourth connection end (28), the third connection end (27) and the fourth connection end (28) are close to a second side face (1902) of the capacitor core (19), and the second side face (1902) is away from the power transistor (11).

6. The inverter (10) according to claim 4, wherein the power transistor (11) comprises a first sub-power transistor (12) and a second sub-power transistor (13), the power transistor body (100) comprises a first sub-power transistor body (122) and a second sub-power transistor body (132), the first sub-power transistor (12) comprises the first sub-power transistor body (122) and the first connection terminal (124), the second sub-power transistor (13) comprises the second sub-power transistor body (132) and the second connection terminal (134), and the first sub-power transistor body (122) and the second sub-power transistor body (132) are stacked and spaced apart in the first direction.

7. The inverter (10) according to claim 6, wherein the first sub-power transistor (12) further comprises a first alternating current terminal (123), the second sub-power transistor (13) further comprises a second alternating current terminal (133), the first alternating current terminal (123) and the second alternating current terminal (133) are disposed close to a second axial end of the capacitor core (19), and the first alternating current terminal (123) is electrically connected to the second alternating current terminal (133).

8. The inverter (10) according to claim 6, wherein the first sub-power transistor (12) further comprises a first signal end (121), the first signal end (121) extends in a direction away from the second sub-power transistor body (132), the second sub-power transistor (13) further comprises a second signal end (131), and the second signal end (131) extends in a direction away from the first sub-power transistor body (122); and
the inverter (10) further comprises a first drive board (14) and a second drive board (15); the first drive board (14) is disposed on a side of the first sub-power transistor body (122) that is away from the second sub-power transistor (13) in the first direction, and is connected to the first signal end (121); and the second drive board (15) is disposed on a side of the second sub-power transistor body (132) that is away from the first sub-power transistor body (122) in the first direction, and is connected to the second signal end (131).

9. The inverter (10) according to claim 6, wherein the inverter (10) further comprises a second heat dissipation plate (17), the second heat dissipation plate (17) is disposed between the first sub-power transistor body (122) and the second sub-power transistor body (132), the second heat dissipation plate (17) comprises a first surface and a second surface that are opposite to each other, the first sub-power transistor body (122) is disposed on the first surface, and the second sub-power transistor body (132) is disposed on the second surface; and
a top of the second heat dissipation plate (17) is close to the first axial end of the capacitor core (19), and a bottom of the second heat dissipation plate (17) is close to a second axial end of the capacitor core (19).

10. The inverter (10) according to claim 6, wherein there are a plurality of first sub-power transistors (12), the plurality of first sub-power transistors (12) are disposed in parallel in a second direction, there are a plurality of second sub-power transistors (13), the plurality of second sub-power transistors (13) are disposed in parallel in the second direction, each first sub-power transistor (12) and one second sub-power transistor (13) are electrically connected in a one-to-one correspondence in the first direction, and the second direction intersects the first direction.

11. The inverter (10) according to claim 8, wherein the inverter (10) further comprises a third heat dissipation plate (18), and the third heat dissipation plate (18) is disposed between the second sub-power transistor body (132) and the second drive board (15).

12. The inverter (10) according to claim 11, wherein the third heat dissipation plate (18) comprises a liquid inlet pipe (20) and a liquid outlet pipe (21), an axis of the liquid inlet pipe (20) is approximately perpendicular to the third heat dissipation plate (18), an axis of the liquid outlet pipe (21) is approximately perpendicular to the third heat dissipation plate (18), the liquid inlet pipe (20) is configured to allow coolant to flow in, and the liquid outlet pipe (21) is configured to allow the coolant to flow out.

13. The inverter (10) according to claim 12, wherein a first through hole and a second through hole are provided in the second drive board (15), the liquid inlet pipe (20) passes through the first through hole, and the liquid outlet pipe (21) passes through the second through hole.

14. The inverter (10) according to claim 8, wherein the first drive board (14) and the second drive board (15) are connected through at least one connector (30).

15. The inverter (10) according to any one of claims 1 to 14, wherein the inverter (10) further comprises a case (22), and the capacitor core (19) and the power transistor (11) are jointly potted in the case (22).

16. The inverter (10) according to any one of claims 1 to 14, wherein a size of the inverter (10) in the first direction is L1, a size of the inverter (10) in the second direction is L2, satisfying 0.9≤L1/L2≤1.1, and the second direction intersects the first direction.

17. A motor control unit (40), comprising the inverter (10) according to any one of claims 1 to 14.

18. A powertrain (50), comprising the motor control unit (40) according to claim 17.

19. A vehicle (60), comprising the powertrain (50) according to claim 18.
